Europäisches Patentamt

European Patent Office

Office européen des brevets

(11) Publication number: **0 361 456**
**A2**

## (12) EUROPEAN PATENT APPLICATION

(21) Application number: **89117893.1**

(22) Date of filing: **27.09.89**

(51) Int. Cl.5: **G01R 33/02**

(30) Priority: **30.09.88 JP 128593/88 U**

(43) Date of publication of application:
**04.04.90 Bulletin 90/14**

(84) Designated Contracting States:
**DE FR GB IT**

(71) Applicant: **MURATA MANUFACTURING CO., LTD.**
**2-26-10, Tenjin**
**Nagaokakyo-shi Kyoto(JP)**

(72) Inventor: **Kawanishi, Shinichi**
**3-9-1-318, Gontasaka Hodogaya-ku**
**Yokohama-shi Kanagawa(JP)**
Inventor: **Kumada, Akira**
**2-6-3, Takeyama Midori-ku**
**Yokohama-shi Kanagawa(JP)**

(74) Representative: **Grupe, Peter, Dipl.-Ing. et al**
**Patentanwaltsbüro**
**Tiedtke-Bühling-Kinne-Grupe-Pellmann-Grams-Struif-Roth Bavariaring 4**
**D-8000 München 2(DE)**

(54) **Magnetic sensor.**

(57) A casing is produced by bonding a base plate to a cap and sealing the bonded portion so as to keep the interior of the cap in an air-tight state. A magnetic detector is disposed in the cap such that the magnetic detecting surface of the magnetic detecting element constituting the magnetic detector is in contact with the ceiling of the inner wall of the cap and a holder for holding the magnetic detecting element is separated from the upper surface of the base plate. When the base plate is engaged with the cap, a lead-out terminal from the magnetic detecting element presses the terminal provided on the base plate side directly or indirectly through a conductive material. Since the detecting surface of the magnetic detector is constantly in contact with the ceiling of the inner wall of the cap, the magnetic detection accuracy is enhanced and the electrically connecting operation of a lead-out terminal from the magnetic detecting element is greatly facilitated.

*FIG. 1*

## MAGNETIC SENSOR

### BACKGROUND OF THE INVENTION

#### Field of the Invention

The present invention relates to a magnetic sensor for reading a magnetic code magnetically stored on, for example, a card or detecting the rotation of a magnetic gear.

#### Description of the Prior Art

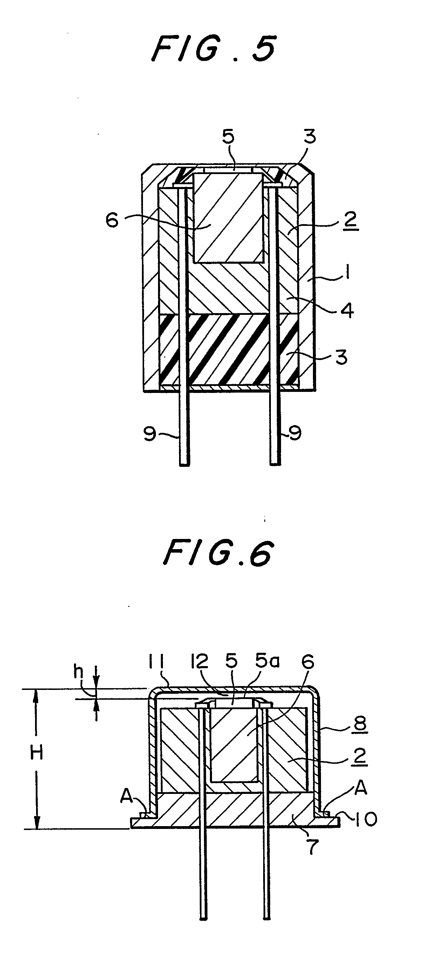

Fig. 5 shows the sectional structure of a conventional magnetic sensor. The magnetic sensor is composed of a magnetic detector 2 embedded in a casing 1 by means of a resin 3 such as an epoxy resin. The magnetic detector 2 is composed of a holder 4 accommodating a magnet 6 and a magnetic detecting element 5 which consists of a magnetoresistive element or the like and is secured to the end surface of the magnet 6 by an adhesive or the like. The detecting surface of the magnetic detector 2 is brought into contact with the inner end surface of the casing 1. From the base end side of the holder 4, a terminal 9 for driving the magnetic detecting element 5 and taking out the output of the magnetic detection from the magnetic detecting element 5 projects to the outside through the resin 3.

This kind of magnetic sensor, however, is embedded in the casing 1 by means of the resin 3 such as an epoxy resin. Therefore, when the magnetic sensor is used in an environment of a very high or low temperature, the thermal stress produced on the resin 3 acts on the magnetic detecting element 5 and fluctuates the sensor output or, in the worst case, breaks the magnetic detecting element 5.

When this kind of magnetic sensor is used in an environment of a high humidity, the moisture acts on the adhesive for bonding the magnetic detecting element 5 and the magnet 6 through the resin 3, thereby disadvantageously destroying the adhesion. In this way, a conventional magnetic sensor is inconvenient for use in that it cannot be used or preserved in an environment of an extremely high or low temperature or a high humidity.

To eliminate such inconvenience, what is called a hermetic sealing type magnetic sensor is recently used in which the holder 4 of the magnetic detector 2 is fixed on a base plate 7 and a cap 8 is hermetically sealed to the base plate 7, as shown in Fig. 6. In this magnetic sensor, the base plate 7 and the cap 8 are hermetically sealed at the bonded portion A by welding, and the cap 8 is sucked into a vacuum state. In this hermetic sealing type magnetic sensor, since the base plate 7 and the cap 8 are bonded by welding, the moisture does not enter the cap 9 even in a high-humidity environment. In addition, since a resin such as an epoxy resin is not charged into the cap 8, the thermal stress does not act on the magnetic detecting element 5 unlike the magnetic sensor shown in Fig. 5, so that the inconvenience caused by the magnetic sensor shown in Fig. 5 such as the breakage of the magnetic detecting element 5 in an environment of a very high or low temperature and lowering the adhesion in a high-humidity environment is eliminated.

In the hermetic sealing type magnetic sensor shown in Fig. 6, however, since the base plate 7 and the cap 8 are bonded by welding, the welded state at the bonded portion of the base plate 7 and the cap 8 is different in each sensor and, hence, the H from the bonded surface 10 of the cap 8 to the top surface 11 thereof is different in each sensor. The distance h between the magnetic detecting surface 5a of the magnetic detector 5 and the top surface 11 of the cap 8 is therefore also different and inconstant in each sensor.

As well known, in order to enhance the detection accuracy of a magnetic sensor, it is necessary to shorten the distance h between the magnetic detecting surface 5a and the top surface 11. In order to enhance the reliability of the magnetic detection, it is necessary to make the value of h constant. In the hermetic sealing type sensor, however, the value of h is not constant, as described above, and since a gap 12 is produced between the magnetic detecting surface 5a and the ceiling of the inner wall of the cap 8, the value of h becomes comparatively large. Accordingly, this type of magnetic sensor is disadvantageous in that it is impossible not only to obtain the reliability of magnetic detection but also to sufficiently enhance the magnetic detection accuracy.

#### Description of the Related Art

To solve such problems, the present inventor has proposed a magnetic sensor in which the base plate 7 is separated from the magnetic detector 2 with a space therebetween, and the magnetic detecting surface 5a on the side of the magnetic detector 2 is brought into close contact with the opposite inner wall surface of the cap 8 so as to prevent the fluctuation of the distance h between the magnetic detecting surface 5a and the top surface 11 of the cap 8 due to the welded state of the cap 8. In this way, if the magnetic detecting surface 5a is brought into close contact with the opposite ceiling of the inner wall of the cap 8, the value of h is equal to the thickness of the top wall of the cap 8 and, hence, constant in spite of the fluctuation of the value of H. It is therefore possible to enhance the magnetic detection accuracy and the reliability of the magnetic detection.

However, a new problem is produced when the magnetic detector 2 is separated from the base plate 8. That is, the connection between the terminal on the side of the magnetic detector 2 and the terminal on the side of the base plate 7 becomes very difficult. More specifically, when the magnetic detector 2 is separated from the base plate 7, it is impossible to take a large gap between them because the room within the cap 8 is small. Therefore, when the terminals are connected with each other by a wiring material by soldering or the like, the soldering operation is not easy and troublesome.

Thus, the related art also has a problem in the operability at the time of connecting terminals.

## SUMMARY OF THE INVENTION

Accordingly, it is an object of the present invention to eliminate the above-described problems in the prior art and the related art and to provide a magnetic sensor in which a gap is provided between the magnetic detector and the base plate and which facilitates the connection between the terminals on the side of the magnetic detector and on the side of the base plate in spite of the arrangement the magnetic detector and the base plate with a gap therebetween.

To achieve this aim, the present invention provides a magnetic sensor comprising:
a casing composed of a base plate and a cap bonded with each other with the bonded portion sealed by hermetic sealing such that the interior of the cap is in an air-tight state;
a magnetic detector composed of a magnetic detecting element, a holder for holding the magnetic detecting element, a lead-out terminal made of an elastic material, the magnetic detector being provided in the cap with the magnetic detecting surface of the magnetic detecting element in contact with the ceiling of the inner wall of the cap and with a gap between the bottom surface of the holder and the upper surface of the base plate; and
a terminal on the side of the base plate which is electrically connected with the lead-out terminal from the magnetic detecting element in the casing;
the terminal on the side of the base plate and the lead-out terminal from the magnetic detecting element being electrically connected with each other by bringing one into close contact with the other directly or indirectly through a conductive material.

In the magnetic sensor of the present invention having the above-described structure, the cap accommodates and fixes the magnetic detecting element of the magnetic detector such that the magnetic detecting surface comes into contact with the ceiling of the inner wall of the cap in a contact state. In this state, when the base plate is fitted into the cap, the terminals on the side of the magnetic detector and on the side of the base plate are brought into close contact with each other directly or indirectly through a conductive material and electrically connected. In other words, the conductive connection between the terminal on the side of the magnetic detector and the terminal on the side of the base plate is achieved without using a wiring material.

The above and other objects, features and advantages of the present invention will become clear from the following description of the preferred embodiments thereof, taken in conjunction with the accompanying drawings.

## BRIEF DESCRIPTION OF THE DRAWINGS

Fig. 1 is a sectional view of a first embodiment of a magnetic sensor according to the present invention;

Fig. 2 is an explanatory view of the positional relationship between a first terminal on the side of a magnetic detector and a second terminal on the side of a base plate;

Fig. 3 is a sectional view of a second embodiment of a magnetic sensor according to the present invention;

Fig. 4 is a sectional view of a third embodiment of a magnetic sensor according to the present invention;

Fig. 5 is a sectional view of the structure of a conventional magnetic sensor; and

Fig. 6 is a sectional view of a conventional hermetic sealing type magnetic sensor.

## DESCRIPTION OF THE PREFERRED EMBODIMENTS

Embodiments of the present invention will be explained hereinunder with reference to the accompanying drawings. In the explanation of each embodiment, the same reference numerals are provided for the same elements and duplicate explanation thereof will be omitted.

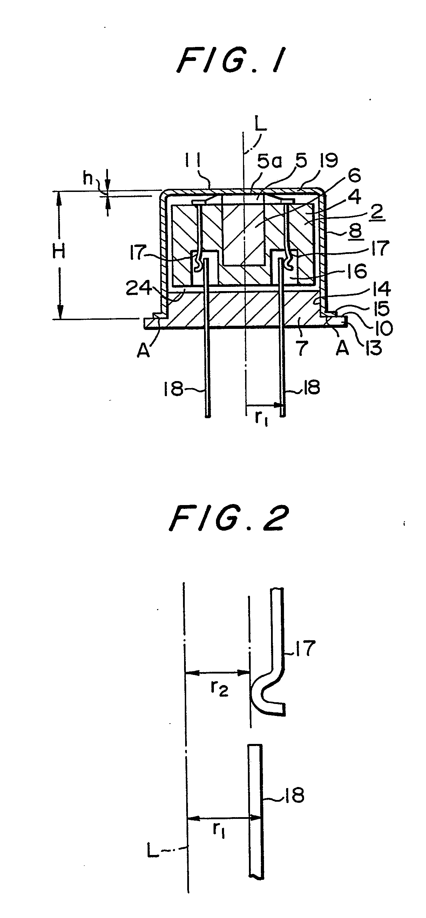

Fig. 1 shows a first embodiment of a magnetic sensor according to the present invention. In Fig. 1, a base plate 7 composed of a metal material has a collar portion horizontally projecting from the bottom portion with the upper surface thereof serving as the cap bonding surface 10 in the same way as the base plate 7 shown in Fig. 6. A cap 8 composed of a nonmagnetic material such as stainless steel is fitted over the body portion 14 of the base plate 7. The inner surface of the cap 8 is coated with a thin insulation film of a material such as glass or hydrogen fluoride, and the end portion of the peripheral wall of the cap 8 is bent horizontally outwardly so as to form a collar-shaped wall portion 15 with the undersurface brought into contact with the cap bonding surface 10. The cap bonding surface 10 and the collar-shaped wall portion 15 are bonded at the bonded surface A by, for example, electric welding or the like so as to form a casing with the interior of the cap 8 isolated from the outside in an air-tight state by what is called hermetic sealing. A holder 4 composed of a nonmagnetic material is accommodated in the cap 8. The holder 4, in turn, accommodates a magnet 6 in a fixed state. A magnetic detecting element 5 composed of a magnetoresistive element is fixed onto the surface of the magnet 6 by an adhesive. The magnetic detecting surface 5a of the magnetic detecting element 5 is secured to the ceiling of the top wall 19 of the cap by an adhesive.

A concave space 16 is formed on the bottom surface on the base end side of the holder 4, and a first terminal 17 for supplying a driving voltage to the magnetic detecting element 5 and taking out the output of magnetic detection from the magnetic detecting element 5 projects into the concave space 16. The first terminal 17 is composed of a conductive material having elasticity, and the end portion of the first terminals 17 is curved. On the base plate 7, a second terminal 18 is fixed. The end of the second terminal 18 projects upward from the base plate 7 into the concave space 16 of the holder 4. In the first embodiment, the radial distance r¹ between the center line L of the cap 8 and the outer side surface of the second terminal 18 is made slightly larger than the distance from the center line L to the inner surface of the curved portion of the first terminal 17, as shown in Fig. 2. Therefore, when the base plate 7 is inserted into the cap 8 with the magnetic detector 2 accommodated therein, the second terminal 18 enters the concave space 16 while pushing outwardly the curved portion of the first terminal 17. In this way, the first terminal 17 and the second terminal 18 are connected in a close contact state, thereby achieving the conductive connection. The base end side of the second terminal 18 projects from the bottom surface of the base plate 7 to the outside of the casing, and is connected to the power circuit and detection signal processing circuit (not shown).

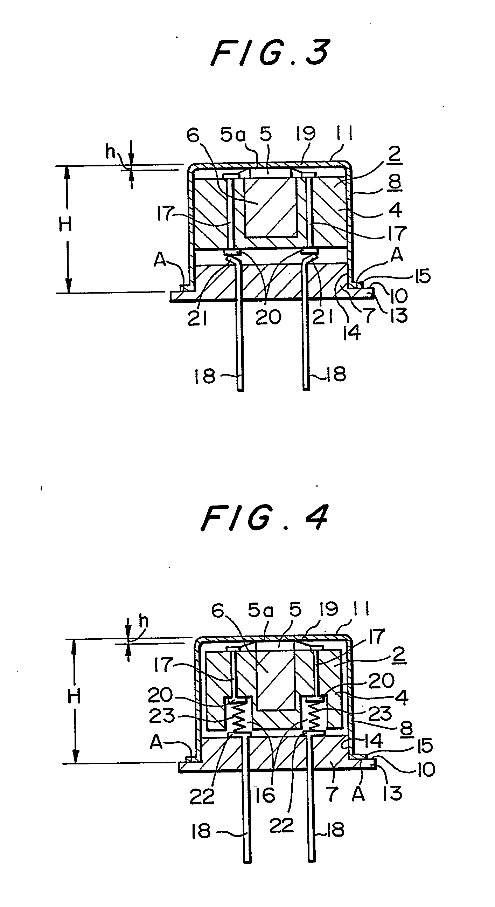

Fig. 3 shows a second embodiment of a magnetic sensor according to the present invention. The second embodiment is the same as the first embodiment except for the manner for connecting the first terminal 17 and the second terminal 18. In the second embodiment, a connecting portion 20 which is conductive with the first terminal 17 is provided on the end surface (bottom surface) side of the holder 4 and the end portion of the second terminal 18 is formed as an elastic upwardly inclined portion 21 so as to provide the end portion with spring resilience. When the base plate 7 is inserted into the cap 8 with the magnetic detector 2 accommodated therein, the elastic upwardly inclined portion 21 of the second terminal 18 abuts the connecting portion 20 of the first terminal 17. In this state, when the base plate 7 is further fitted into the cap 8, the elastic upwardly inclined portion 21 is elastically bent in such a manner as to come into close contact with the connecting portion 20. In the state in which both terminals 17 and 18 are in close contact with each other, the base plate 7 and the cap 8 are hermetically sealed by welding.

Fig. 4 shows a third embodiment of a magnetic sensor according to the present invention. The third embodiment is different from the first and the second embodiments only in that the first terminal 17 and the second terminal 18 are brought into close contact with each other indirectly through a conductive material. In Fig. 4, the concave space 16 is formed on the base end side of the holder 4 in the same way as in the first embodiment, and the connecting portion 20 of the first terminal 17 is provided on the bottom surface side of the concave space 16. A connecting portion 22 of the second terminal 18 is similarly provided on the upper end surface side of the base plate 7. A spring 23 of a conductive material is inserted into the concave space 16 in a contracted state with one end thereof retained by the connecting portion 20 of the first terminal 17 and the other end thereof retained by the connecting portion 22 of the second terminal 18. That is, the spring 23 connects the connecting portions 20, 22 of the terminals 17, 18, respectively, in an indirectly close contact state. In the third embodiment, after the magnetic detector 2 is accommodated in the cap 8, the spring 23 is accommodated in the concave space 16 and thereafter the base plate 7 is inserted into the cap 8, whereby the first terminal 17 and the second terminal 18 is automatically connected with each other in a close contact state through the spring 23.

The present invention is not restricted to these embodiments but various modifications are possible. For example, although the magnetic detecting surface 5a of the magnetic detector 2 is fixed to the inner surface of the top wall of the cap 8 by an adhesive, an elastic material such as rubber may be inserted into the space formed between the magnetic detector 2 and the base plate 7 in Fig. 1 in a compressed state so that the magnetic detecting surface 5a is pressed against the inner wall surface of the cap 8 by utilizing the elastic return force of the elastic material. It is also possible in the magnetic sensors shown in Figs. 3 and 4 to press the magnetic detector 2 against the inner wall surface of the cap 8 by utilizing the elastic return force of the spring 23 and the elastic upwardly inclined portion 21 without using the adhesive.

In the magnetic sensor of the present invention, since the magnetic detector in the cap is separated from the base plate with a space therebetween, it is possible to dispose the magnetic detector with the magnetic detecting surface in contact with the ceiling of the inner wall of the cap in spite of the fluctuation of the welded state. As a result, it is possible to keep the distance between the magnetic detecting surface of the magnetic detector and the sensor detecting surface (top surface of the cap) short and constant, thereby greatly enhancing the magnetic detection accuracy and the reliability of magnetic detection.

Since the terminal on the magnetic detector side and the terminal on the base plate side are connected in close contact with each other, the trouble of soldering the terminals by a wiring material is obviated. In addition, since the terminal on the magnetic detector side and the terminal on the base plate side are automatically connected in close contact with each other merely by fitting the base plate into the cap with the magnetic detector accommodated therein, the connecting operation is greatly facilitated.

In addition, since the magnetic sensor of the present invention is of a hermetic sealing type, the interior of the cap is maintained in a substantially vacuum state, so that the terminals maintained in close contact with each other in the cap are prevented from oxidization and corrosion. Thus, the terminals can maintain the reliable connecting state over a long period without losing the conductive connecting ability of the connecting portion.

While there has been described what are at present considered to be preferred embodiments of the invention, it will be understood that various modifications may be made thereto, and it is intended that the appended claims cover all such modifications as fall within the true spirit and scope of the invention.

A casing is produced by bonding a base plate to a cap and sealing the bonded portion so as to keep the interior of the cap in an air-tight state. A magnetic detector is disposed in the cap such that the magnetic detecting surface of the magnetic detecting element constituting the magnetic detector is in contact with the ceiling of the inner wall of the cap and a holder for holding the magnetic detecting element is separated from the upper surface of the base plate. When the base plate is engaged with the cap, a lead-out terminal from the magnetic detecting element presses the terminal provided on the base plate side directly or indirectly through a conductive material. Since the detecting surface of the magnetic detector is constantly in contact with the ceiling of the inner wall of the cap, the magnetic detection accuracy is enhanced and the electrically connecting operation of a lead-out terminal from the magnetic detecting element is greatly facilitated.

## Claims

1. A magnetic sensor comprising:
a casing composed of a base plate and a cap bonded with each other with the bonded portion sealed by hermetic sealing such that the interior of said cap is in an air-tight state;
a magnetic detector composed of a magnetic detecting element, a holder for holding said magnetic detecting element, and a lead-out terminal made of an elastic material, said magnetic detector being provided in said cap with said magnetic detecting surface of said magnetic detecting element in contact with the ceiling of the inner wall of said cap and with a gap between the bottom surface of said holder and the upper surface of said base plate; and
a terminal on the side of said base plate which is electrically connected with said lead-out terminal from said magnetic detecting element in said casing;
wherein said terminal on the side of the base plate and said lead-out terminal from said magnetic detecting element are electrically connected with each other by bringing one into close contact with the other directly or indirectly through a conductive material.

2. A magnetic sensor according to Claim 1, wherein said base plate constituting said casing is composed of a metal material and the inner surface of said cap is composed of a nonmagnetic material coated with an insulation film.

3. A magnetic sensor according to Claim 1, wherein said base plate and said cap of said casing are bonded with each other by bonding the upper surface of a projecting portion which projects horizontally outward from the bottom surface of said base plate with a projecting portion which is formed at the end portion of the peripheral wall of said cap in such a manner as to project horizontally outward.

4. A magnetic sensor according to Claim 1, wherein said magnetic detecting surface of said magnetic detecting element is brought into contact with said ceiling of the inner wall of said cap by bonding and securing said magnetic detecting surface to said ceiling by an adhesive.

5. A magnetic sensor according to Claim 1, wherein said terminal on the base plate side is so provided as to penetrate said base plate, with the end portion to be connected to said lead-out terminal from said magnetic detecting element projecting toward said holder and the other end being led out from said base plate to the outside of said casing.

6. A magnetic sensor according to Claim 1, wherein
said lead-out terminal is provided at both ends of said magnetic detecting element, with the end portion of each lead-out terminal penetrating said holder to extend to a concave space formed on the bottom surface side of said holder and provided with a curved portion;
said terminal on said base plate side is provided at the positions corresponding to said two lead-out terminals in such a manner as to project from said base plate toward said concave space of said holder; and
when said base plate is engaged with said cap, each of said terminals slides so as to press said curved portion of each of said lead-out terminals, whereby said terminals are conductivity connected with the respective lead-out terminals in a close contact state.

7. A magnetic sensor according to Claim 1, wherein
said lead-out terminal is provided at both ends of said magnetic detecting element, with the end portion of each lead-out terminal penetrating said holder to constitute a connecting portion exposed to a concave space formed on the bottom surface of said holder;
said terminal on said base plate side is provided at the positions facing said two lead-out terminals in such a manner as to project from said base plate and an elastic inclined portion is provided at the end portion of each of the projecting terminals; and
when said base plate is engaged with said cap, each of said elastic inclined portions is pressed so as to be in close contact with the corresponding connecting portion.

8. A magnetic sensor according to Claim 7, wherein
said magnetic detecting surface of said magnetic detecting element, which is a component of said magnetic detector, is brought into contact with said ceiling of the inner wall of said cap by pressing said magnetic detecting surface against said ceiling of said inner wall of said cap by the compression force of said elastic inclined portions of said base plate side terminals to said connecting portions.

9. A magnetic sensor comprising:

a casing composed of a base plate and a cap bonded with each other with the bonded portion sealed by hermetic sealing such that the interior of said cap is in an air-tight state;
a magnetic detector composed of a magnetic detecting element, a holder for holding said magnetic detecting element, and a lead-out terminal from said magnetic detecting element, said magnetic detector being provided in said cap with said magnetic detecting surface of said magnetic detecting element in contact with the ceiling of the inner wall of said cap and with a gap between the bottom surface of said holder and the upper surface of said base plate; and
a terminal on the side of said base plate which is electrically connected with said lead-out terminal from said magnetic detecting element in said casing;
wherein said lead-out terminal from said magnetic detecting element and said terminal on the side of said base plate are electrically connected with each other by bringing one into close contact with the other indirectly through a conductive material.

10. A magnetic sensor according to Claim 9, wherein
said lead-out terminal is provided at both ends of said magnetic detecting element, with the end portion of each lead-out terminal penetrating said holder to constitute a connecting portion exposed to a concave space formed on the bottom surface of said holder;
said terminal on said base plate side is provided at the positions facing said two lead-out terminals with each end portion constituting a connecting portion exposed to the position on said base plate facing the corresponding connecting portion of said lead-out terminal; and
each opposing pair of said connecting portions are connected with each other by a conductive spring which is disposed in said concave space and urges said connecting portions so as to be compressed.

11. A magnetic sensor according to Claim 10, wherein said magnetic detecting surface of said magnetic detecting element constituting said magnetic detector is brought into contact with said ceiling of the inner wall of said cap by pressing said magnetic detecting surface against said ceiling of said inner wall of said cap by the compression force of said conductive spring which urges said connecting portions of said lead-out terminals from said magnetic detecting element so as to be compressed against said connecting portions of said terminals on the side of said base plate.

# FIG. 1

# FIG. 2

# FIG.3

# FIG.4

# FIG. 5

# FIG.6